# EUROPEAN PATENT SPECIFICATION

(11) **EP 1 420 002 B1**
(45) Date of publication and mention of the grant of the patent: **09.09.2009**
(21) Application number: 02751698.8
(22) Date of filing: 25.07.2002
(51) Int. Cl.: C04B 35/01, C23C 14/34, C23C 14/24, C01B 33/113

(54) **SILICON MONOXIDE SINTERED PRODUCT AND METHOD FOR PRODUCTION THEREOF**
SILICIUMMONOXID-SINTERPRODUKT UND HERSTELLUNGSVERFAHREN DAFÜR
PRODUIT FRITTE EN MONOXYDE DE SILICIUM ET SON PROCEDE DE PRODUCTION

(30) Priority: 26.07.2001 JP 2001225652; 01.08.2001 JP 2001233034
(43) Date of publication of application: 19.05.2004
(73) Proprietor: OSAKA Titanium Technologies Co., Ltd., Amagasaki-shi Hyogo 660-8553 (JP)
(72) Inventor: NATSUME, Yoshitake, Itami-shi, Hyogo 664-0873 (JP); ONISHI, Takashi, Nishinomiya-shi, Hyogo (JP); OGASAWARA, Tadashi, Nishinomiya-shi, Hyogo 663-8181 (JP); WATANABE, Munetoshi, Suita-shi, Osaka 565-0843 (JP); IWASE, Toshiharu, Kobe-shi, Hyogo 651-2113 (JP)
(74) Representative: Butler, Lance
(86) International application number: PCT/JP2002/007570
(87) International publication number: WO 2003/010112

(56) References cited:
- JP-A- 5 171 412
- JP-A- 6 057 417
- JP-A- 7 310 177
- JP-A- 9 143 689
- JP-A- 9 143 690
- JP-A- 63 166 965
- JP-A- 63 310 961
- JP-A- 2002 069 618
- JP-A- 2002 097 567
- JP-A- 2002 194 535
- US-A- 3 010 839

## Description

### TECHNICAL FIELD

This invention relates to an improved silicon monoxide sinter, which is a material used in vapor phase film production such as vacuum vapor deposition and sputtering, and more particularly relates to a silicon monoxide sinter and a method for manufacturing this sinter, in which a raw material powder is sintered by hot pressing under a specific range of hot pressing conditions and using an inner die divided into a plurality of segments and a cushioning material, which gives a vapor deposition material that has excellent mechanical workability, a uniform texture, and is splash resistant, and also gives excellent flatness in the desired shape for a sputtering target.

### BACKGROUND ART

Thin films obtained by forming a film of silicon monoxide by vacuum vapor deposition or another such method not only have good adhesion to a variety of materials, have high insulation resistance, and have excellent dielectric characteristics, they are also easy to produce by vapor deposition at a relatively low temperature, among other advantages.

Because of the above-mentioned excellent characteristics, vapor deposited films of silicon monoxide have been utilized in many different applications, and applications that make use of their optical characteristics, for instance, include protective films and antireflective films for glass and the like, antireflective films for solar cells, and thin film capacitors that make use of the insulating characteristics of these films.

Furthermore, these films have good gas blocking properties against oxygen, water vapor, odors, and so forth, and are deposited onto plastic films to create gas barrier films for use in the packaging of foods, drugs, precision electronic components, and so forth.

These silicon monoxide films are produced by various vapor deposition methods, or by sputtering or other such processes, so the silicon monoxide vapor deposition material or sputtering target that serves as the film formation raw material is worked into the shape required by the film formation method in question.

The vapor deposition material used to produce the above-mentioned silicon monoxide vapor deposition films is generally a lump of silicon monoxide obtained by heating and reacting a mixture of metallic silicon powder and silicon dioxide powder in a vacuum, and depositing the silicon monoxide vapor thus produced onto a precipitation substrate with a relatively low temperature. Alternatively, a raw material containing the scrap generated in the production of a silicon monoxide lump can be used instead of the above-mentioned mixture.

The above-mentioned silicon monoxide lump is difficult to machine because it is brittle and prone to chipping, so it is crushed into smaller lumps of an easy-to-use size, such as flakes crushed to about 50 mm in size. These small lumps of silicon monoxide are used as the vapor deposition material in electron beam vapor deposition, resistance heating vapor deposition, plasma heating vapor deposition, and so on.

A silicon monoxide lump manufactured by vacuum vapor deposition does not have a uniform texture. The portion precipitated on the substrate at the beginning of the vapor deposition has an acicular texture, and a problem encountered when this portion is vapor deposited over a film is that splashing occurs frequently. This problem does not occur near the surface of the vapor deposition material subsequently precipitated over the substrate.

A method in which a film is continuously produced by continuously supplying a silicon monoxide vapor deposition material has been studied in recent years in an attempt to boost the productivity of films produced by electron beam heating vapor deposition. A method in which a granular raw material is continuously supplied to a heating vessel in order to continuously supply a vapor deposition material is possible, but the problem here is that severe splashing occurs. To deal with this, it is also possible to perform continuous film production by continuously supplying long, cylindrical or prismatic vapor deposition material particles from beneath a water-cooled bottomless crucible and heating the upper surface of the vapor deposition material with an electron beam or plasma beam, but conventional vapor deposition materials are brittle and difficult to machine, and they are so heterogeneous that they are difficult to use even if the portion with acicular texture is removed.

Meanwhile, Japanese Laid-Open Patent Application S63-310961 proposes a method for inexpensively manufacturing a silicon monoxide vapor deposition material, in which a silicon powder and a silicon dioxide powder are dry mixed, press molded, and sintered, and this sinter is used as a silicon monoxide vapor deposition material. This sintering method does allow the material to be manufactured at a relatively low cost, but the bulk density is low and the above-mentioned problem of splashing is not sufficiently prevented.

Splashing could not be satisfactorily suppressed in the manufacture of a silicon monoxide vapor deposition material obtained by a conventional vacuum condensation method, or the above-mentioned vapor deposition material obtained by dry mixing, press molding, and sintering a silicon powder and a silicon dioxide powder.

Also, a problem encountered with the latter sintering method was that sublimation and film growth occurred after silicon monoxide was produced by heating and reacting silicon and silicon dioxide, resulting in slower film growth.

Meanwhile, a vapor deposition material is sometimes machined so that it will fit the shape of the target holder of the vapor deposition apparatus to be used. However, with a silicon monoxide vapor deposition material obtained by a conventional vacuum condensation method, or by dry mixing, press molding, and sintering the raw material powders, cracking and chipping routinely occur during this machining, making it difficult to machine the material to the desired shape.

Silicon monoxide is also used as a sputtering target. This target material needs to be machined into a shape that will fit in the target holder of the sputtering apparatus, needs to have a high density in order to minimize particle generation during sputtering, and needs to have a uniform texture.

The preferred density of a sputtering target is such that the bulk density is at least 95% of the true density. Since the true density of silicon monoxide is 2.24 g/cm³, a bulk density that is at least 95% of the true density corresponds here to at least 2.13 g/cm³.

Japanese Laid-Open Patent Applications H9-143689 and H9-143690 propose a porous vapor deposition material obtained by wet molding a slurry containing a silicon powder and a silicon dioxide powder, gelling the material in the course of this molding, and drying and firing the molded article thus obtained. The vapor deposition material described in these publications has a bulk density of only 0.67 to 1.57 g/cm³ (corresponding to a true density of 30 to 70%), meaning that there is concern about the generation of particles during sputtering.

The vapor deposition material discussed in the above-mentioned Japanese Laid-Open Patent Application S63-3109961 is a mixed sinter of a silicon powder and a silicon dioxide powder. Virtually no reaction occurs between the silicon powder and the silicon dioxide powder, the bulk density is about 1.2 to 1.3 g/cm³, and a sinter with a bulk density of 2.13 g/cm³ or higher cannot be obtained.

Further, Japanese Laid-Open Patent Application S63-166965 discusses a method for obtaining a target from a molded article obtained by mixing silicon dioxide and metallic silicon, heating this mixture in a vacuum to sublimate and precipitate silicon monoxide, and crushing and then pressing and sintering this silicon monoxide. However, in experiments conducted by the inventors, since a property of silicon monoxide is that it sublimates from a solid into a gas at about 1200 °C in a vacuum, the pressing and sinteringwere performed at 1150 °C, which is believed to be the upper limit for the heating temperature under the sublimation temperature, but the bulk density of the sinter was only about 1.3 g/cm³.

The bulk density of a sinter of silicon monoxide never exceeded 1. 5 g/cm³ with any of the conventional manufacturing methods.

### DISCLOSURE OF THE INVENTION

It is an object of the present invention to solve the problems encountered with the prior art discussed above, and to provide a silicon monoxide sinter that is easy to machine, has good splash resistance and uniformity, and can be utilized as a silicon monoxide vapor deposition material with which continuous film production is possible by vacuum vapor deposition.

It is a further object of the present invention to provide a silicon monoxide sinter for use as a sputtering target, which can be easily put into a shape that allows mounting in a target holder, and which has a high density and uniform texture that suppress the generation of particles.

As a result of various investigations into increasing the density and the texture uniformity of a silicon monoxide sinter, the inventors discovered that a powder obtained from a silicon monoxide lump produced by vacuum vapor deposition cannot be molded and sintered, and in particular that although a silicon monoxide lump with a bulk density of at least 1. 95 g/cm³ can be obtained, when this lump is machined into a sputtering target there will be variance in the Vickers hardness in the thickness direction, so the texture can hardly be considered uniform, which means that cracks and chipping will occur throughout the material during machining, making this material impossible to use.

The inventors then conducted follow-up study, focusing on the fact that the machinability and splash resistance of a sinter can be enhanced by raising the bulk density of the sinter, and investigated press molding with this in mind, which led to the discovery that with the silicon monoxide powders obtained by all manufacturing methods, even if pressing and sintering are carried out at 1150 °C, which is believed to be the upper limit to the heating temperature under the sublimation temperature, the bulk density of the sinter will only be about 1.3 g/cm³, and cannot be raised any further.

Also, as a result of diligent study into the pressing and sintering process, the inventors have learned that when a raw material is sintered while being pressed and molded in a vacuum, and when this is press molded at 1200 °C or higher, which is above the subl imat ion temperature of silicon monoxide, a silicon monoxide sinter will be obtained in the desired shape without any sublimation occurring, and that the resulting sinter will have a bulk density of at least 1.6 g/cm³, and that if the sintering temperature is raised to 1250 °C or higher, bonding by sintering will be further promoted between the raw material atoms, and as a result a sinter with a bulk density of at least 2.13 g/cm³ will be obtained.

Further, the inventors perfected the present invention upon discovering that, in the above method in which a material is sintered under heating conditions over the sublimation temperature while being pressed and molded, there is the danger that as the size of the material increases, cracks will begin to develop in the sinter during the cooling that follows sintering, or the press die will be damaged, but if the press die is designed so that an inner die divided into a plurality of segments is put together inside an integrated outer die with a cushioning material interposed therebetween it will be easy to obtain a sputtering target with a diameter of 100 mm or more.

Specifically, the present invention is method for manufacturing a silicon monoxide sinter having a bulk density of at least 1.68[1] g/cm³, wherein a press die is packed with lump particles of silicon monoxide and/or a powder of silicon monoxide, and this material is sintered by being subjected to hot pressing at a pressure of 10 MPa or higher, a sintering temperature of 1200 to 1350 °C, and a holding time of at least 30 minutes.

Also, in the manufacturing method of the present invention constituted as above, a silicon monoxide sinter with a bulk density of at least 2.2 g/cm³, which is nearly the same as its true density, can be obtained under conditions comprising a pressure of at least 15 MPa, a sintering temperature of 1300 to 1350 °C, and a holding time of 1 hour or longer.

### BRIEF DESCRIPTION OF THE DRAWINGS

Fig. 1 is an oblique view in which part of the press die used in the manufacturing method of the present invention has been cut away:

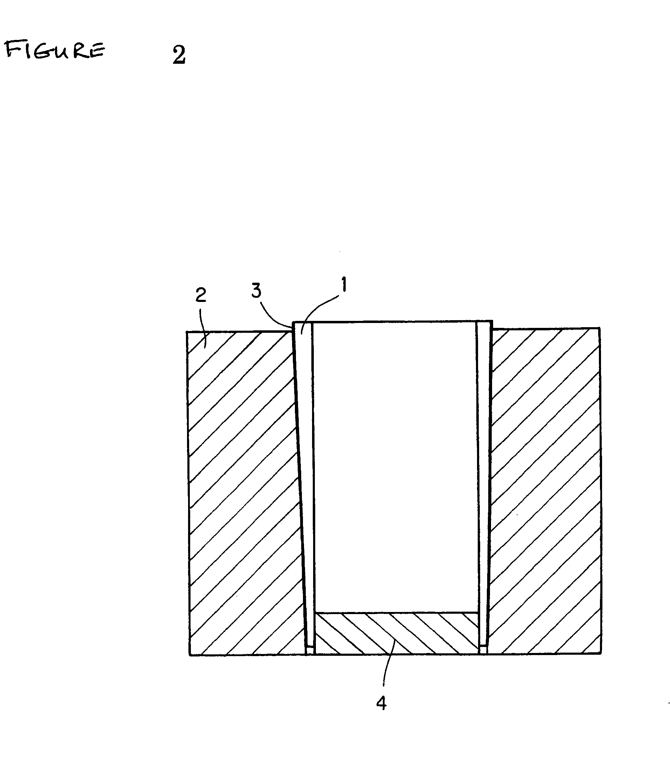

Fig. 2 is a front view of a vertical cross section of the press die shown in Fig. 1, in a state in which the inner die has been shifted upward slightly; and
Fig. 3 is a diagram illustrating an example of a vacuum vapor deposition apparatus in which a silicon monoxide vapor deposition material made from the sinter of the present invention is continuously supplied to a water-cooled copper crucible, and a film is continuously formed under irradiation with an electron beam.

### BEST MODE FOR CARRYING OUT THE INVENTION

The silicon monoxide sinter obtained with the present invention has a bulk density of at least 1.6 g/cm³, and depending on the hot pressing conditions, it is possible to obtain a silicon monoxide sinter with a bulk density of at least 2. 13 g/cm³, or even 2.2 g/cm³, which is nearly the same as the true density of silicon monoxide.

Also, the silicon monoxide sinter pertaining to the present invention has a bulk density of at least 1.6 g/cm³ and has excellent machinability, allowing a vacuum vapor deposition to be machined into various shapes, and also has a uniform texture, and exhibits splash resistance that is excellent for a vacuum vapor deposition.

The silicon monoxide sinter obtained with the present invention can be hot press molded into a material of the required form that matches the shape of the target holder and has a diameter of at least 100 mm, making it useful as a sputtering target material, and this sinter will have a uniform texture and a bulk density of at least 2.13 g/cm³, which is at least 95% of the true density, so there will be little particle generation and a good sputtering rate can be achieved.

The method for manufacturing a silicon monoxide sinter pertaining to the present invention is such that a press die is packed with grains and/or a powder of silicon monoxide, and the material is sintered by being subjected to hot pressing at a pressure of 10 MPa or higher, a sintering temperature of 1200 to 1350 °C, and a holding time of at least 30 minutes, and preferably at least 1 hour (excluding a case 1200 °C and 10 MPa). There are no particular restrictions on the powder of sil icon monoxide that serves as the raw material in the present invention, or on the manufacturing method or properties thereof, but it is preferable to use a raw material composed of a mixture of a metallic silicon powder and a silicon dioxide powder, and to heat and react this material in a vacuum, and crush the silicon monoxide lump thus produced.

The lump of silicon monoxide that serves as the raw material in the present invention can be flakes made from a lump of silicon monoxide produced by vacuum vapor deposition, or these flakes can be crushed into smaller flakes. It is also possible to use granules or a powder made from the above-mentioned lump.

The particle size of the silicon monoxide powder in the present invention is preferably at least 250 µm and no more than 2 mm. Specifically, if the size is less than 250 µm, the particle surface area will be too large and the oxygen concentration will increase, and there will also be the danger of foul ing brought about by crushing during the powder manufacture, so it is best to use a powder of at least 250 µm, but it is also undesirable for the size to be over 2 mm because the packing rate will decrease when the material is put into the inner die.

With the hot pressing pertaining to the present invention, when the bulk density of the resulting silicon monoxide sinter is from 1.6 to 2. 1 g/cm³, as the density rises the sinter vitrifies, but does not become transparent, and in some cases may appear still to have some granularity. If the bulk density is over 2. 1 g/cm³, however, the material will turn transparent and will increasingly vitrify, so the sintering raw material in hot pressing in which a bulk density of at least 2.1 g/cm³ is desired can be the above-mentioned flakes of silicon monoxide produced directly by vacuum vapor deposition, or these can be crushed into smaller flakes, allowing sintering to be performed at a higher pressure and temperature.

There are no particular restrictions on the vacuum atmosphere in the present invention, but it is preferable to create sufficient vacuum and deaerate [the material] in advance so that gases and so forth will not be released from the raw material powder during sintering. Methods that can be employed, for instance, are to reduce the pressure to about 1 × 10-2 Torr and then perform the hot pressing, or to introduce argon gas after the pressure has been reduced.

The reason the pressing load is stated to be at least 10 MPa and the sintering temperature 1200 to 1350 °C in the present invention is mainly so a sinter with a bulk density of at least 1.6 g/cm³ will be obtained by using the proper combination of pressing load and sintering temperature. However, as will be clear from the examples, a case in which the temperature is 1200 °C and the pressure is 10 MPa is excluded because the bulk density will be less than 1.6 g/cm³, but the bulk density will increase to at least 1.6 g/cm³ if the temperature is only 1200 °C but the pressure is over 10 MPa, or if the pressure is only 10 MPa but the temperature is over 1200 °C. Raising the atmosphere temperature tends to have a particularly pronounced effect in terms of increasing the bulk density.

Specifically, if the temperature is lower than 1200 °C, there will be no increase in density and a sinter of the desired shape will not be obtained, but at 1350 °C a sinter will be obtained with a bulk density of 2. 24 g/cm³, which is equal to the true density, so there is no need to heat the material beyond 1350 °C.

Also, if the pressing load is at least 10 MPa, and particularly if it is at least 15 MPa, the desired density will be obtained in the proper temperature combination, so there are no particular restrictions on this pressing load, but exceeding 20 MPa will have no additional effect of increasing density, so a pressure within the range of 20 MPa or less is adequate.

The holding time of the hot pressing in the present invention will vary with the combination of pressing load and sintering temperature, but a minimum of 30 minutes is required, and an hour or longer is necessary to obtain a good sinter. 1 to 2 hours is preferable.

In the present invention, a silicon monoxide sinter with a bulk density of at least 2.13 g/cm³ will be obtained when the pressure is from 15 to 20 MPa, the sintering temperature is from 1250 to 1350 °C, and the holding time is at least one hour.

It is also possible to obtain a silicon monoxide sinter with a bulk density of at least 2.2 g/cm³ when the pressure is at least 15 MPa, the sintering temperature is from 1300 to 1350 °C, and the holding time is at least one hour.

In the present invention, the material is sintered under heating conditions over the sublimation temperature of 1200 °C while being pressed and molded, but cracks may form in the sinter or the press die may be damaged during the cooling that follows sintering, although the cause of this is not entirely clear. In view of this, the inventors conducted various investigations, and reached the conclusion that the press die contracts during the cooling that follows sintering, but the sinter conversely expands during cooling from the sintering temperature, so the inventors were able to prevent cracking in the sinter during cooling by employing a structure that allows the stress caused by volumetric expansion to be relieved in a graphite press die used for hot pressing.

Specifically, they prevented cracking in the sinter during cooling by using a combination press die in which an inner die divided into, say, two or three segments is put together in an integrated outer die with the segments separated by a specific gap, and a cushioning material is interposed in these gaps, as a press die structure that would allows the stress produced by volumetric expansion to be relieved. The above-mentioned cushioning material can be a sheet composed of a material that freely expands and contracts through elasticity, such as a carbon fiber sheet or a silica-based fiber sheet.

When a press die comprises an inner die divided into a plurality of segments that are put together inside an integrated outer die with a gap therebetween, if this die is packed with a commercially available silicon monoxide powder, for example, and this powder is sintered at a sintering temperature of 1250 to 1350 °C while being pressed and molded in a vacuum, a large, high-quality silicon monoxide sinter with a diameter of at least 100 mm and a height of at least 50 mm, and a uniform texture, can be manufactured efficiently, without undergoing any cracking or chipping.

The phrase " a diameter of at least 100 mm" here refers to a sinter that can be machined to a diameter of 100 mm for use as a sputtering target.

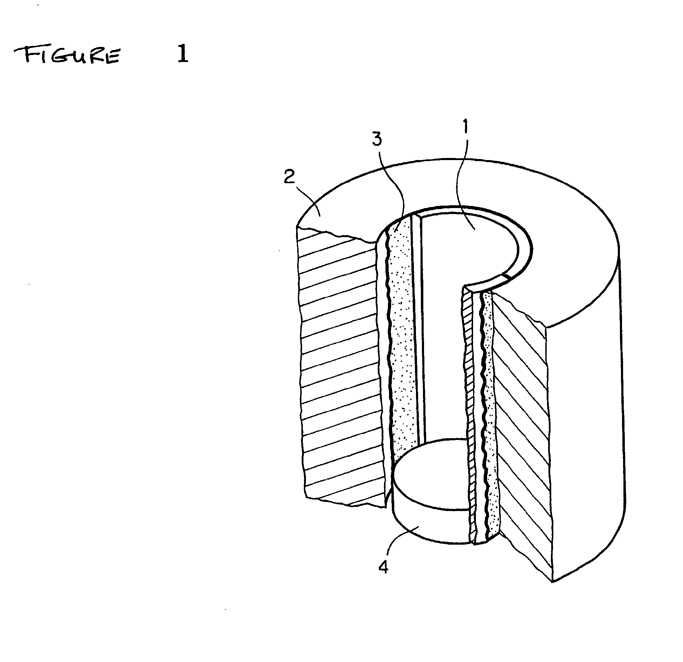

An example of the above-mentioned combination press die will now be described through reference to the drawings. Fig. 1 illustrates a combination press die used to manufacture a cylindrical sinter. A graphite inner die 1 is a split die that is divided in two in the radial direction and tapers downward to the required wall thickness. A graphite outer die 2 is similarly tapered in its inside diameter so that the above-mentioned inner die 1 can fit therein with a gap of about 1 mm, for example, therebetween.

When the inner die 1 is fitted into the outer die 2, an annular cushioning material 3 is fitted into the gap between these dies. This cushioning material 3 consists of a material that can expand and contract through elasticity in the radial direction, such as a carbon fiber sheet or a silica-based fiber sheet.

When the sinter is removed after sintering, a bottom punch 4 is pushed up from below, opening a gap between the inner die 1 and the outer die 2 and allowing the sinter to be taken out of the inner die 1. The removed inner die is taken apart so that the sinter can be easily separated and recovered.

A raw material silicon monoxide powder is packed into a press die comprising the above-mentioned two-piece inner die I and the one-piece outer die 2, which are put together with the cushioning material 3 interposed therebetween, and the sinter obtained by sintering this powder while pressing and molding in a vacuum expands during cooling, but because the split inner die 1 is pushed outward and the cushioning material 3 is compressed, the stress that is generated by the expansion of the sinter as the inner die 1 opens outward can be absorbed, which prevents cracking or chipping from occurring during cooling.

This structure allows a silicon monoxide sinter to be manufactured with a diameter of 110 mm and a height of 40 mm, as in the examples below, but if the inside diameter of the inner die 1 is further enlarged to 200, 300, or 400 mm, and the height changed as needed, a large sinter can be manufactured as desired.

### Examples

### Example 1

A raw material composed of a mixture of a metallic silicon powder and a silicon dioxide powder was heated and reacted in a vacuum to produce a silicon monoxide lump, which was crushed into a silicon monoxide powder with a minimum particle size of 0.3 mm and a maximum particle size of 1.7 7 mm. This powder was pressed under various pressures (9 to 20 MPa) under a vacuum of 10 MPa using a commercially available hot pressing apparatus having a graphite die. The holding time was variously set at 1150 °C, 1200 °C, 1250 °C, and 1300 °C, and sinters with a diameter of 50 mm and a thickness of 20 mm were manufactured.

The bulk density of the resulting sinters was measured. These results are shown in Table 1 along with the hot pressing conditions. Characteristics examined for the resulting sinters were machinability, splash resistance when used as a vacuum vapor deposition material uniformity, and cracking. These results are given in Table 2.

Machinabilty was evaluated from how long it took to cut the material down to the vapor deposition material size, and from the extent of cracking or chipping that occurred. Splash resistance was evaluated from the properties of the obtained vapor deposition film. Uniformity was evaluated from the state after sublimation for a specific time, and is indicated in the table by a "○" (good), "Δ" (fair), or " ×" (poor).

It can be seen from the results in Table 1 that the bulk density of the sinters in Comparative Examples 1 to 5, which did not meet the two conditions specified in the present invention, namely, that the sintering temperature be 1200 to 1300 °C and the pressing pressure be at least 15 MPa, was 1. 52 g/cm³ or less in every case. In contrast, in Examples 1 to 5 of the present invention, the bulk density was at least 1.68 g/cm³ in every case, and in particular the bulk densitywhen a sinter was produced at a high temperature of 1300 °C was 2.24 g/cm³, which is equal to the true density.

Also, an examination of the characteristics of the sinters in Table 2 reveals that uniformity was good in all of Comparative Examples 1 to 5, but machinability was inferior and splash resistance was poor. In contrast, in Examples 1 to 5 of the present invention, uniformity was good in every case, and both machinability and splash resistance were excellent.

When the density is 2. 13 g/cm³ or higher, the material is vitreous, and in rare cases cracking may occur during sublimation when a large amount of heating is performed by electron beam.

**Table 1**

| | | Hot pressing conditions | | | Bulk density (g/cm³) |
|---|---|---|---|---|---|
| | | Heating temperature (° C) | Holding time (hr) | Pressing pressure (MPa) | |
| Comparative Example | 1 | 1150 | 1 | 10 | 1. 21 |
| | 2 | 1150 | 1 | 15 | 1. 30 |
| | 3 | 1150 | 1 | 20 | 1. 34 |
| | 4 | 1200 | 1 | 10 | 1. 42 |
| | 5 | 1250 | 1 | 9 | 1. 52 |
| Present invention | 6 | 1200 | 1 | 15 | 1. 68 |
| | 7 | 1200 | 1 | 20 | 1. 75 |
| | 8 | 1250 | 1 | 15 | 2. 13 |
| | 9 | 1250 | 1 | 20 | 2. 18 |
| | 10 | 1300 | 1 | 20 | 2. 24 |

**Table 2**

| | No. | Sinter characteristics | | | Cracking during vapor deposition |
|---|---|---|---|---|---|
| | | Machin-ability | Splash resistance | Uni-formity | |
| Comparative Example | 1 | △ | × | ○ | none |
| | 2 | △ | × | ○ | none |
| | 3 | △ | × | ○ | none |
| | 4 | △ | △ | ○ | none |
| | 5 | △ | △ | ○ | none |
| Present invention | 6 | ○ | ○ | ○ | none |
| | 7 | ○ | ○ | ○ | none |
| | 8 | ○ | ○ | ○ | none |
| | 9 | ○ | ○ | ○ | rarely |
| | 10 | ○ | ○ | ○ | rarely |

| | | | | | |
|---|---|---|---|---|---|
| "○" (good). " Δ" (fair), " ×" (poor) | | | | | |

### Example 2

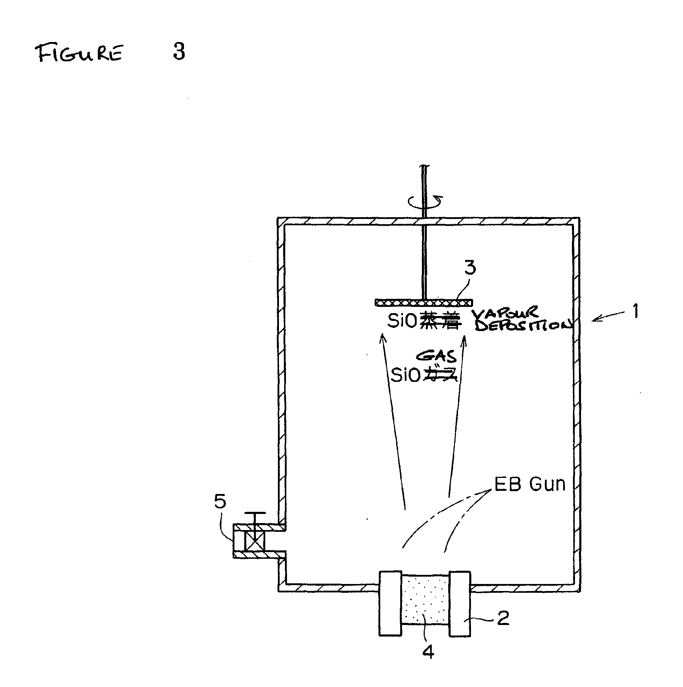

The silicon monoxide sinter obtained by implementing present invention No. 8 in Example 1 was cut down to a diameter of 30 mm and a thickness of 20 mm, which was accomplished without any cracking or chipping. Using the silicon monoxide vapor deposition material thus obtained, a vapor deposition film was formed with the vacuum vapor deposition apparatus 1 shown in Fig. 3.

The vacuum vapor deposition apparatus 1 comprised a water-cooled, bottomless cylindrical crucible 2 provided at the bottom of a vacuum chamber having an exhaust port 5, a rotary shaft rotated by an external drive source was disposed at the top of the vacuum chamber facing the crucible, and at the lower end of this shaft was provided a glass vapor deposition substrate 3.

This vacuum vapor deposition apparatus 1 was kept in a vacuum state by purging the inside of the chamber through the exhaust port 5, a vapor deposition material 4 composed of a silicon monoxide sinter was inserted into the water-cooled crucible 2, the surface of the vapor deposition material 4 was irradiated with an electron beam and thereby heated and sublimated, and the silicon monoxide was vapor deposited onto the lower surface of the vapor deposition substrate 3 to build up a film. Here, it is also possible to continuously form silicon monoxide films on a plurality of substrates by continuously supplying five vapor deposition materials to the water-cooled crucible 2 from below, continuously heating and sublimating the vapor deposition material 4, and intermittently replacing the vapor deposition substrates 3 using a substrate replacement apparatus (not shown).

The film formation rate with a continuous vacuum vapor deposition apparatus using a vapor deposition material produced from the silicon monoxide sinter pertaining to the present invention was comparable to that of a conventional non-continuous vapor deposition apparatus, and a good silicon monoxide film could be formed without any pinholes being caused by splashing.

Because there was so little splashing during vapor deposition, there was no need to halt the vapor deposition midway, and five vapor deposition materials could be used continuously without any cracking occurring.

### Example 3

A raw material composed of a mixture of a metallic silicon powder and a silicon dioxide powder was heated and reacted in a vacuum to produce a silicon monoxide lump, which was crushed into three types of silicon monoxide powder with a particle size (minimum to maximum) of 0.3 to 1.7 mm (type A), 0.45 mm or less (type B), and 5 to 15 mm (type C).

Just as in Example 1, pressing was performed using a hot pressing apparatus having a graphite die, under a vacuum of 10 MPa, at four different pressing pressures of 9 MPa, 10 MPa, 15 MPa, and 20 MPa, at five different sintering temperatures of 1150 °C, 1200 °C, 1250 °C, 1300 °C, and 1350 °C, and for a holding time of 1 hour, to manufacture sinters with a diameter of 50 mm and a thickness of 10 mm. The bulk density of the sinters thus obtained was measured, the results of which are given in Table 3. It can be seen from the results in Table 3 that the bulk density of the sinter of Comparative Examples 11 to 15, in which the hot pressing conditions did not meet the requirements for sintering temperature and pressing pressure stipulated in the present invention, was less than 1.6 g/cm³ in every case, making these materials unsuitable as vapor deposition materials, and the bulk density did not even reach the 2.13 g/cm³ level required for a sinter to be used as a sputtering target.

In contrast, in Examples 16 to 26 of the present invention, the bulk density was at least 1. 60 g/cm³ in every case, and was at least 2.13 g/cm³ under conditions of at least 1250 °C and at least 15 MPa, and the bulk density was 2.24 g/cm³, or equal to the true density, when the sintering was performed at a high temperature of 1300 to 1350 °C.

**Table 3**

| | | Raw material | Hot pressing conditions | | | Bulk density (g/cm³) |
|---|---|---|---|---|---|---|
| | | | Heating temperature (° C) | Holding time (hr) | Pressing pressure (MPa) | |
| Comparative Example | 11 | B | 1150 | 1 | 10 | 1. 21 |
| | 12 | B | 1150 | 1 | 15 | 1. 30 |
| | 13 | B | 1150 | 1 | 20 | 1. 34 |
| | 14 | B | 1200 | 1 | 10 | 1. 42 |
| | 15 | B | 1250 | 1 | 9 | 1. 52 |
| Present invention | 16 | B | 1200 | 1 | 11 | 1. 60 |
| | 17 | B | 1200 | 1 | 13 | 1. 61 |
| | 18 | A | 1200 | 1 | 15 | 1. 68 |
| | 19 | A | 1200 | 1 | 20 | 1. 75 |
| | 20 | A | 1250 | 1 | 10 | 1. 62 |
| | 21 | A | 1250 | 1 | 15 | 2. 13 |
| | 22 | A | 1250 | 1 | 20 | 2. 18 |
| | 23 | A | 1300 | 1 | 15 | 2. 24 |
| | 24 | A | 1350 | 1 | 20 | 2. 24 |
| | 25 | B | 1300 | 1 | 20 | 2. 24 |
| | 26 | C | 1300 | 1 | 20 | 2. 24 |

### Example 4

A raw material composed of a mixture of a metallic silicon powder and a silicon dioxide powder was heated and reacted in a vacuum to produce a silicon monoxide lump, which was crushed into two types of silicon monoxide powder with a particle size of 0. 3 to 0.17 mm (type A) and 5 to 15 mm (type C). Each of these was put into the hot pressing apparatus having combination press die shown in Fig. 1, in which an inner die that is divided in two is incorporated in an integrated outer die with a cushioning material (carbon fiber sheet) interposed therebetween. While being pressed and molded in this hot pressing apparatus under a vacuum of 10 MPa, at pressing pressures of 15 MPa and 20 MPa, the silicon monoxide powder was sintered at a sintering temperature of 1250 to 1300 °C for a holding time of 1 hour, to produce sinters with a diameter of 110 mm and a height of 40 mm.

As comparative examples, the silicon monoxide powder was sintered, using an integrated graphite press die commonly used, at a sintering temperature of 1150 to 1200 °C for a holding time of 1 hour, to produce sinters with a diameter of 110 mm and a height of 40 mm.

The sinters thus obtained were measured for bulk density and checked for cracks, the results of which are given in Table 4. It can be seen from these results that numerous cracks and chips occurred in the comparative examples, in which the sinteringwas performed in a conventional integrated press die, and a large sinter suitable for practical use could not be obtained.

In contrast, when a combination press die comprising a split inner die and an integrated outer die with a cushioning material interposed therebetween was used as in the examples of the present invention, a large sinter with a diameter of 110 mm and a bulk density of at least 2.13 g/cm³ could be manufactured at a high level of productivity without any cracking or chipping occurring.

The resulting materials of the present invention in which the bulk density was at least 2.13 g/cm³, which is at least 95% of the true density, were used as sputtering targets, the sputtering rate was measured, and the generation of particles was evaluated, the results for both of which were found to be excellent.

**Table 4**

| | | Raw material | Hot pressing conditions | | | Bulk density (g/cm³) | Cracking |
|---|---|---|---|---|---|---|---|
| | | | Tempe-ra ture (° C) | Time (Hr) | Pressing pressure (MPa) | | |
| Comparati ve Example | 27 | A | 1150 | 1 | 15 | 1. 32 | very much |
| | 28 | C | 1200 | 1 | 20 | 1. 72 | very much |
| Present invention | 29 | A | 1250 | 1 | 15 | 2. 14 | none at all |
| | 30 | C | 1300 | 1 | 20 | 2. 24 | none at all |

### Example 5

A silicon monoxide raw material manufactured by vacuum vapor deposition in addition to the raw material shown in Table 4 of Example 4 was machined without first being crushed, and was thereby cut into a disk with a diameter of about 105 mm and a thickness of about 25 mm. Chipping occurred in this machining, but one disk was placed on top of another and used as a sintering raw material, and sintering was performed under hot pressing conditions comprising a temperature of 1300 °C, a pressure of 20 MPa, and a holding time of 1 hour. As a result, a sinter with a bulk density of 2.24 g/cm³ was obtained.

### INDUSTRIAL APPLICABILITY

The silicon monoxide sinter pertaining to the present invention has a bulk density of at least 1. 60 g/cm³, has excellent mach inability that allows it to be worked into various shapes of vacuum vapor deposition material, and has a uniform texture and exhibits excellent splash resistance as a vacuum vapor deposition material. Specifically, vacuum vapor deposition can be carried out continuously by continuously supplying a vapor deposition material as with the vacuum vapor deposition apparatus shown in Fig. 3.

The silicon monoxide sinter obtained with the present invention can be hot press molding into a material having a diameter of at least 100 mm, which is useful for a sputtering target material, and having the require shape fitting the shape of a target holder. Also, the texture of the sinter is uniform and the bulk density thereof is at least 2.13 g/cm³, which is at least 95% of the true density, very few particles are generated, and a good sputtering rate is attained.

## Claims

1. A silicon monoxide sinter having a bulk density of at least 1.60 g/cm³.

2. The silicon monoxide sinter according to Claim 1 having a bulk density of at least 2.13 g/cm³.

3. The silicon monoxide sinter according to Claim 2 which is a sputtering target material having a diameter of at least 100 mm.

4. A silicon monoxide sintered target having a silicon monoxide sinter as defined in Claim 3.

## Patentansprüche

1. Siliciummonoxid-Sinterkörper, der eine Rohdichte von wenigstens 1,60 g/cm³ aufweist.

2. Siliciummonoxid-Sinterkörper gemäß Anspruch 1, der eine Rohdichte von wenigstens 2,13 g/cm³ aufweist.

3. Siliciummonoxid-Sinterkörper gemäß Anspruch 2, bei dem es sich um ein Targetmaterial für die Kathodenzerstäubung handelt, das einen Durchmesser von wenigstens 100 mm hat.

4. Target aus gesintertem Siliciummonoxid, das einen Siliciummonoxid-Sinterkörper gemäß Anspruch 3 aufweist.

## Revendications

1. Produit fritté en monoxyde de silicium ayant une masse volumique apparente d'au moins 1,60 g/cm³.

2. Produit fritté en monoxyde de silicium selon la revendication 1 ayant une masse volumique apparente d'au moins 2,13 g/cm³.

3. Produit fritté en monoxyde de silicium selon la revendication 2 qui est un matériau cible de pulvérisation ayant un diamètre d'au moins 100 mm.

4. Cible frittée en monoxyde de silicium ayant un produit fritté en monoxyde de silicium selon la revendication 3.
